(19) Europäisches Patentamt
European Patent Office
Office européen des brevets

(11) **EP 2 786 425 B1**

(12) **FASCICULE DE BREVET EUROPEEN**

(45) Date de publication et mention de la délivrance du brevet:
**02.03.2016 Bulletin 2016/09**

(21) Numéro de dépôt: **12790573.5**

(22) Date de dépôt: **26.11.2012**

(51) Int Cl.:
*H01L 31/103* $^{(2006.01)}$       *H01L 31/18* $^{(2006.01)}$

(86) Numéro de dépôt international:
**PCT/EP2012/073629**

(87) Numéro de publication internationale:
**WO 2013/079446 (06.06.2013 Gazette 2013/23)**

(54) **DIODE P/N À HÉTÉROSTRUCTURE CONTROLÉE AUTOPOSITIONNÉE SUR HGCDTE POUR IMAGEURS INFRAROUGES**

P-N DIODE FÜR INFRAROT-BILDGEBER MIT EINER KONTROLLIERTEN UND SELBSTPOSITIONIERTEN HGCDTE HETEROSTRUKTUR

P-N DIODE HAVING A CONTROLLED HETEROSTRUCTURE SELF-POSITIONED ON HGCDTE, FOR INFRARED IMAGERS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.11.2011 FR 1103617**

(43) Date de publication de la demande:
**08.10.2014 Bulletin 2014/41**

(73) Titulaire: **Commissariat à l'Énergie Atomique et aux Énergies Alternatives 75015 Paris (FR)**

(72) Inventeurs:
• **MOLLARD, Laurent**
  **38640 Claix (FR)**
• **BAIER, Nicolas**
  **F-38330 Biviers (FR)**
• **ROTHMAN, Johan**
  **38000 Grenoble (FR)**

(74) Mandataire: **Ahner, Philippe et al**
  **BREVALEX**
  **95, rue d'Amsterdam**
  **75378 Paris Cedex 8 (FR)**

(56) Documents cités:
**EP-A1- 0 229 574        US-A1- 2003 071 221
US-A1- 2007 034 898**

## Description

## DOMAINE TECHNIQUE

La présente invention est relative au domaine des diodes fabriquées dans des matériaux semiconducteurs. L'invention a trait plus précisément aux diodes de type p/n formées dans des substrats à base de matériaux du type $Hg_{1-x}Cd_xTe$, et qui peuvent être utilisées pour des imageurs infrarouges.

## ÉTAT DE LA TECHNIQUE ANTÉRIEURE

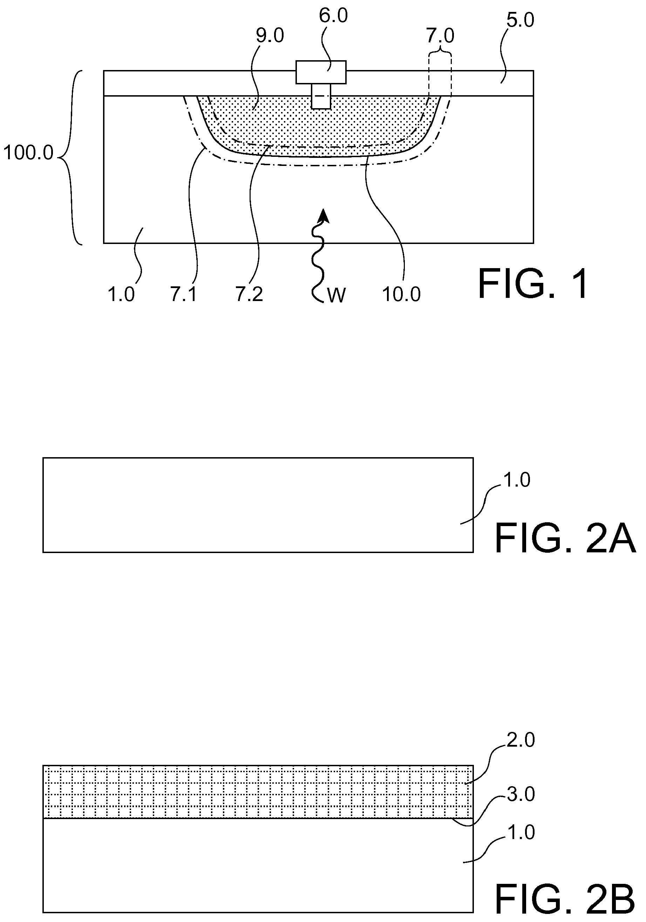

Les diodes p/n sont généralement formées dans un substrat 100.0 ayant majoritairement un dopage n. Elles comportent dans ce substrat 100.0 une région de dopage n, appelée semelle 1.0 (figure 1) et une zone 9.0 dopée p+, dite de dopage p, voisine avec la semelle 1.0. L'interface entre la région de dopage n 1.0 et la zone 9.0 dopée p+ est communément appelée «jonction p/n » 10.0. A l'équilibre thermodynamique, une zone de charge d'espace 7.0 se forme de part et d'autre de la jonction p/n 10.0. En une première limite 7.1 de la zone de charge d'espace 7.0, la semelle 1.0 dopée n est chargée positivement et en une seconde limite 7.2 de la zone de charge d'espace, la zone 9.0 dopée p+ est chargée négativement induisant un champ électrique intense.

Lorsqu'une onde électromagnétique W pénètre dans le substrat par la semelle 1.0, elle forme une paire électron-trou par interaction avec des atomes du matériau de la semelle 1.0. Un porteur minoritaire dans la semelle, ici un trou, diffuse d'une longueur de diffusion de trou dans la semelle 1.0 avant de se recombiner avec un porteur majoritaire, ici un électron. Si le porteur minoritaire diffuse jusque dans la zone de charge d'espace 7.0, il ne se recombine pas immédiatement. Il est accéléré par le champ électrique vers la zone 9.0 dopée p+. Il s'y recombine en formant un courant inverse entre la zone 9.0 dopée p+ et la semelle 1.0 de dopage n.

Si l'onde électromagnétique W traverse la semelle 1.0 et que la génération de la paire électron/trou a lieu dans la zone de charge d'espace 7.0, la paire est instantanément séparée par le champ électrique. Le trou est dirigé vers la seconde limite 7.2 et vers la zone 9.0 dopée p+ et l'électron vers la première limite 7.1 et vers la semelle 1.0 de dopage n. Ce phénomène est plus rare que le précédent, et demande généralement que la semelle 1.0 doit très fine, l'onde électromagnétique W devant traverser la totalité de la semelle 1.0.

Une diode p/n n'est sensible qu'à des longueurs d'ondes dont l'énergie est suffisante pour faire franchir le gap du matériau de la semelle 1.0 à un électron pour former des paires électron/trou. Il faut donc qu'une onde électromagnétique ait une énergie minimale pour être détectée. Inversement, si l'onde électromagnétique a une énergie très supérieure au gap, l'onde électromagnétique interagit fortement avec la semelle 1.0 et la majorité des paires électrons-trous sont formées trop loin de la jonction p/n et les trous se recombinent avec un porteur majoritaire sans permettre une détection de l'onde. Ainsi le gap du matériau de la semelle 1.0 définit une longueur d'onde minimale qui peut être captées par la diode et une gamme de longueurs d'ondes pouvant être détectées de façon optimale.

Dans une diode en matériau $Hg_{1-x}Cd_xTe$, le gap du matériau, et donc la gamme des longueurs d'ondes détectées par cette diode, dépend de la concentration en cadmium dans la semelle 1.0. Une faible concentration en cadmium assure un petit gap à la diode et la détection d'ondes électromagnétiques de grande longueur d'onde. Cependant un petit gap induit une sensibilité accrue de la diode aux défauts et un courant d'obscurité plus important. En particulier, s'il y a des défauts dans un matériau, le gap s'en trouve artificiellement réduit en quelques points localisés du matériau. Dans un matériau à petit gap cette réduction artificielle est plus importante proportionnellement au gap.

Le courant d'obscurité est une imperfection des photodiodes causée par l'agitation thermique. Dans une certaine mesure, l'agitation thermique peut fournir une énergie suffisante à certains électrons pour former une paire électron-trou par génération spontanée. Si le trou formé par génération spontanée apparaît dans la zone de charge d'espace ou proche de la jonction p/n, il y a formation d'un courant en l'absence d'onde électromagnétique incidente sur la diode.

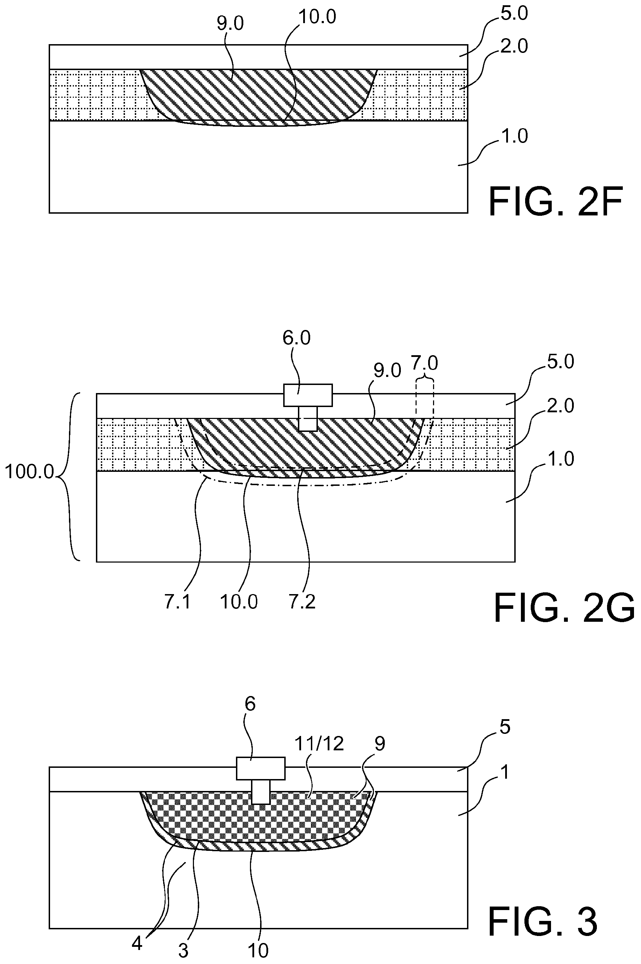

Pour limiter le courant d'obscurité dans les imageurs infrarouges à petit gap, une possibilité est de fabriquer des diodes dites « à hétérostructure » telles qu'illustrées en figure 2G. Une telle structure et un procédé pour la fabriquer sont décrits dans l'article « MBE HgCdTe Heterostructure p-on-n Planar Infrared Photodiodes » de J.M Arias et al. publié en 1993 dans « Journal of Electronic Materials », volume 22, numéro 8, pages 1049 à 1053. La fabrication d'une diode à hétérostructure signifie que l'on va former une diode p/n, ayant une jonction p/n 10.0 et une zone de charge d'espace 7.0 autour de celle-ci, telle que la semelle 1.0 de la diode soit dans un matériau ayant un petit gap, mais que la jonction p/n 10, ou en particulier la seconde limite 7.2 de la zone de charge d'espace 7.0 soit dans un matériau ayant un gap plus important. Dans ce cas, la génération spontanée de paires électron-trous dans la zone de charge d'espace 7.0 est réduite, car l'énergie à fournir pour former une paire électron-trou est plus importante que dans la semelle 1.0. Alors la diode est moins sensible aux défauts et au courant d'obscurité.

Cependant, il faut pouvoir récupérer le courant produit par l'absorption d'une onde électromagnétique dans la semelle 1.0. La jonction p/n 10.0 doit être alors située suffisamment proche de la semelle 1.0 ayant un faible gap, plus particulièrement de façon à ce que la première limite 7.1 de la zone de charge d'espace 7.0 soit dans la semelle 1.0 à faible gap.

Ainsi, la diode est telle que la majorité de la zone 9.0 dopée p+ se trouve dans une partie du substrat 100.0 ayant une concentration en cadmium plus importante que la semelle 1.0 sans pour autant être dans la couche de passivation 5.0 dont un des éléments est du cadmium Cd. Une telle configuration conduit la diode à pouvoir capter une gamme de longueurs d'ondes comprenant des longueurs d'ondes faibles, dépendant du gap de la semelle 1.0, tout en étant moins sensible au bruit, au courant d'obscurité et aux défauts qu'une diode sans hétérostructure.

L'homme du métier sait employer, pour former une diode à hétérostructure, un substrat 100.0, dans lequel la semelle 1.0 est formée d'une couche de base de type $Hg_{1-x}Cd_xTe$, avec « x » valant par exemple 0,22, et d'une couche superficielle 2.0, en $Hg_{1-y}Cd_yTe$ où « y » a une valeur supérieure à celle de « x », par exemple 0,28, en contact avec la semelle 1.0. La couche superficielle 2.0 a un gap plus important que la semelle 1.0. On appelle hétérojonction 3.0 l'interface entre la semelle 1.0 et la couche superficielle 2.0.

Une zone 9.0 dopée p+, dite de dopage p, est alors formée dans la couche superficielle 2.0 de façon à ce que la zone 9.0 dopée p+ ait une épaisseur supérieure à celle de la couche superficielle 2.0 et dépasse légèrement l'hétérojonction 3.0. Une jonction p/n 10.0 est définie par une interface entre la zone 9.0 dopée p+ et la semelle 1.0 dopée n. La jonction p/n 10.0 dépasse de la couche superficielle 2.0 de façon à ce qu'au moins la première limite 7.1 de la zone de charge d'espace 7.0 soit située dans la semelle 1.0. La jonction p/n 10.0 est alors positionnée dans une zone de la semelle 1.0 dans laquelle du cadmium de la couche superficielle 2.0 peut avoir légèrement diffusé.

De façon usuelle, une telle diode à base de $Hg_{1-x}Cd_xTe$ est recouverte d'une couche de passivation 5.0 dont est des éléments est du cadmium Cd, pour stabiliser la diode. De plus, pour faire fonctionner la diode, un contact conducteur 6.0 est présent dans la zone 9.0 dopée p+ pour récupérer tout courant produit dans la diode.

Un procédé de réalisation d'une diode à hétérojonction selon l'état de la technique est décrit en figure 2A à 2G.

En premier lieu il est choisi un substrat initial formant une semelle 1.0 en $Hg_{1-x}Cd_xTe$ (figure 2A). La valeur de « x » peut être par exemple 0,22. Cette valeur est choisie de façon à ce que le gap du $Hg_{1-x}Cd_xTe$ soit le gap voulu pour détecter des ondes électromagnétiques données qui ont une énergie minimale correspondant à ce gap. La semelle 1.0 peut typiquement avoir une épaisseur de quelques dixièmes de micromètres à quelques dizaines de micromètres, par exemple 10 $\mu m$.

De préférence la semelle 1.0 comporte initialement un dopage n établi au moyen d'un ou plusieurs dopants de type donneurs, introduits lors de sa fabrication. Sans introduction de dopants extrinsèques, la semelle 1.0 peut être de type n ou p.

Par-dessus la semelle 1.0 est formée, tel qu'illustré en figure 2B, par épitaxie, par jet moléculaire ou par épitaxie en phase liquide, une couche superficielle 2.0 en $Hg_{1-y}Cd_yTe$ où « y » a une valeur strictement supérieure à celle de « x », par exemple 0,28. La couche superficielle 2.0 peut avoir une épaisseur de, par exemple, 1 $\mu m$. Elle forme un substrat 100.0 avec la semelle 1.0. L'interface 3.0 entre la semelle 1.0 et la couche superficielle 2.0 est appelée hétérojonction 3.0.

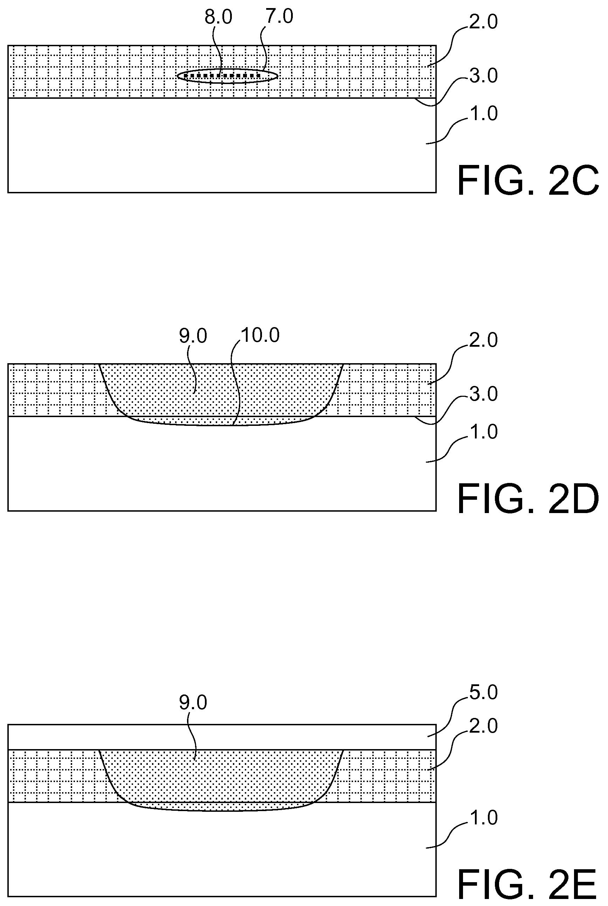

Ensuite, un dopant 8.0, de type accepteur est introduit dans une zone à doper située dans la couche superficielle 2.0 au moyen d'une implantation ionique (figure 2C). L'implantation ionique implante le dopant 8.0 à une profondeur déterminée sous la forme d'atomes de dopants, et forme une zone d'implantation 70.0 contenant le dopant 8.0.

Ensuite est effectuée une diffusion du dopant 8.0. La diffusion déplace les atomes de dopants et crée ainsi une forme classique de région de dopage pour une diode p/n (figure 2D). Puis a lieu une activation du dopant 8.0, cette activation fait que les atomes de dopants sont introduits dans le réseau cristallin de la semelle 1.0. Ainsi, par exemple, l'activation d'un dopant tel que l'arsenic déplace les atomes d'arsenic en substitution d'atomes de tellure dans la couche superficielle 2.0 et dans la semelle 1.0. L'activation conduit à la formation d'une zone 9.0 dopée p+. La diffusion et l'activation du dopant sont généralement regroupées en une seule étape de diffusion et d'activation.

Cette étape de diffusion et d'activation est optimisée pour faire diffuser le dopant jusqu'à ce que l'interface entre la zone 9.0 dopée p+ et le restant de la couche superficielle 2.0 et de la semelle 1.0 soit positionnée à proximité de l'hétérojonction 3.0. Cette interface s'étend au-delà de la couche superficielle 2.0 dans la semelle 1.0. Une jonction p+/n 10.0 sera formée au niveau de cette interface comme il le sera expliqué plus loin. En parallèle, cette étape de diffusion et d'activation entraîne la formation de lacunes de mercure, qui dopent, avec un dopage de type p, l'ensemble du substrat 100.0, semelle 1.0, couche superficielle 2.0 et zone 9.0 dopée p+ comprises. L'interface entre la zone 9.0 dopée p+ et le restant de la semelle 1.0 et de la couche superficielle 2.0 devient une jonction p+/p. Par esprit de simplification nous appellerons cette interface jonction p/n 10.0.

De préférence, on essaye de positionner la jonction p/n 10.0 dans la semelle 1.0, à la limite de l'hétérojonction 3.0, de façon à ce que la jonction p/n 10.0 soit dans une zone ayant une concentration en cadmium intermédiaire entre celle de la semelle 1.0 et celle de la couche superficielle 2.0.

Précédant ou suivant l'étape de diffusion et d'activation du dopant, une couche de passivation 5.0 dont un des éléments est du cadmium Cd, est déposée par-dessus la couche superficielle 2.0 (figure 2E). Cette couche a pour intérêt de protéger la structure de la diode p/n.

Pour transformer la jonction p+/p précitée en une jonction p+/n 10.0, l'homme du métier sait procéder à une étape de comblement des lacunes de mercure suite aux étapes décrites précédemment. L'étape de comblement des lacunes de mercure a pour objectif d'annuler le dopage p induit par la formation de défauts lors de l'implantation ionique et de l'étape de diffusion et d'activation du dopant. Suite à cette étape de comblement des lacunes, la semelle 1 avec un dopant de type donneur retrouve un dopage de type n (figure 2F). La jonction p+/p devient alors une jonction p+/n 10.0 communément appelée jonction p/n.

Ensuite on ajoute un contact conducteur 6.0, de préférence métallique (figure 2G). Ce contact traverse la couche de passivation 5.0 et pénètre dans la zone 9.0 dopée p+ sans atteindre la semelle 1.0. Le contact conducteur 6.0 peut être formé par des techniques classiques en microélectronique. Il est ensuite relié à un circuit électrique extérieur non représenté. Des contacts secondaires non représentés sont généralement formés à l'extérieur de la diode et ils sont destinés à créer un contact électrique entre la semelle 1.0 dopée n et le circuit électrique extérieur. Les deux types de contacts fonctionnant conjointement peuvent servir à récupérer tout courant pouvant apparaître au niveau de la jonction p/n 10.0 par exemple sous l'influence d'une onde électromagnétique.

Les inconvénients d'un tel montage d'une diode à hétérostructure sont nombreux.

Les références dans le texte qui suit se rapportent à la figure 2G illustrant une diode p/n à hétérostructure obtenue par un procédé selon l'état de la technique.

En premier lieu, il est difficile de faire croître une couche superficielle 2.0 en $Hg_{1-y}Cd_yTe$ exempte de défauts cristallins, et en particulier il est difficile d'obtenir une hétérojonction 3.0 exempte de défauts. En dépit du coût en temps et en argent dépensé pour réduire les risques, des défauts sont généralement toujours présents, fragilisant alors les jonctions p/n 10.0 des diodes et les rendant plus sensibles au bruit.

Une deuxième limitation est que l'hétérojonction 3.0 est présente sur l'ensemble du substrat 100.0. La possibilité d'avoir des défauts cristallins dans le substrat 100.0, apportés par la présence de l'hétérojonction 3, est donc importante.

Une troisième limitation réside dans le fait que la position relative de la jonction p/n 10.0 vis-à-vis de l'hétérojonction dépend de la diffusion du dopant et en particulier des conditions de l'implantation et des conditions du recuit de diffusion et d'activation du dopant. L'implantation et la diffusion des dopants est un phénomène aléatoire et statistique qu'il est difficile de maîtriser finement.

En utilisant ce procédé de fabrication de diodes p/n à hétérostructure, la position relative de la jonction p/n 10.0 par rapport à l'hétérojonction 3.0 est donc difficile à maîtriser. On n'est jamais vraiment sûr que la jonction p/n 10.0, en limite de l'hétérojonction 3.0, atteigne la semelle 1.0 ni, à l'inverse, qu'elle ne dépasse pas trop.

Quatrièmement, comme annoncé précédemment, on cherche à ce que la jonction p/n 10.0 soit située avantageusement dans la semelle 1.0, proche de la couche superficielle 2.0, là où il y a un gradient de concentration en cadmium. Une faible différence de profondeur de la jonction p/n 10.0 entre deux diodes voisines conduit à ce que la jonction p/n 10.0 soit en un point différent du gradient et donc avec une concentration en cadmium différente au niveau de la jonction p/n 10.0. La jonction p/n 10.0 peut donc être positionnée dans un matériau de gap différent d'une diode à une autre.

En ajoutant ce phénomène à celui décrit précédemment pour la troisième limitation, on se rend compte que la concentration exacte en cadmium au niveau de la jonction p/n 10.0 est difficilement prévisible et maîtrisable. Les performances de la diode, par exemple le rendement quantique, le courant d'obscurité ou la gamme des longueurs d'ondes captées peuvent donc varier de diodes à diodes. Il y a donc un risque de ne pas obtenir un même signal pour un même flux radiatif d'une diode à une autre.

## EXPOSÉ DE L'INVENTION

Une diode à hétérostructure à jonction p/n selon l'invention et le procédé selon l'invention visent à diminuer l'impact de ces limitations. En particulier ils visent à produire une hétérojonction de meilleure qualité, à moindre coût, à faciliter la maîtrise d'une position relative de la jonction p/n par rapport à l'hétérojonction et à améliorer la reproductibilité et la répétabilité de cette position relative d'un substrat à l'autre et d'une diode à l'autre dans un même substrat.

L'invention concerne donc en premier lieu un dispositif à au moins une diode p/n à hétérostructure, comportant un substrat à base de $Hg_{1-x}Cd_xTe$, majoritairement dopé n. Le substrat comporte pour chaque diode :

- une première partie ayant une première concentration en cadmium,
- une deuxième partie ayant une deuxième concentration en cadmium, supérieure à la première concentration en cadmium, la deuxième partie, dite partie concentrée, formant une hétérostructure avec la première partie,
- une zone dopée p+, dite aussi de dopage p, située dans la partie concentrée et s'étendant jusque dans la première partie, et formant une jonction p/n avec une portion de la première partie appelée semelle, dopée n.

Le substrat est dopé n par introduction de donneurs extrinsèques.

Le dispositif selon l'invention est caractérisé en ce que la partie concentrée est localisée uniquement dans la zone dopée p+ et forme un caisson de concentration en cadmium sensiblement constante. Un tel dispositif permet de résoudre les problèmes précités. En effet, comme l'hétérostructure est contenue dans la zone dopée p+, elle n'est pas présente dans le substrat hors de la ou des diodes du dispositif. Ainsi, il ne peut y avoir de problèmes liés à l'hétérostructure entre deux diodes voisines. De plus, la première partie, ayant une première concentration en cadmium, est accessible pour subir des traitements aux abords des diodes, sans être recouverte par une couche superficielle ayant une autre concentration en cadmium tel que c'est le cas dans les structures de l'état de la technique.

Préférentiellement, le caisson a un fond situé à une distance relative moyenne sensiblement constante vis-à-vis de la jonction p/n. Ainsi, un dispositif selon l'invention permet une maîtrise des performances de la diode, avec une réduction de variations de distance relative moyenne vis-à-vis de l'état de la technique.

Lorsque le dispositif selon l'invention comporte au moins deux diodes p/n à hétérostructure voisines, les caissons des deux diodes voisines sont disjoints et la distance relative moyenne dans l'une des deux diodes est sensiblement égale à la distance relative moyenne dans l'autre diode, assurant une position relative entre la jonction p/n et l'hétérojonction sensiblement identique pour chaque diode et une fiabilité de performances pour chaque diode. En effet, chaque diode ayant une position relative sensiblement identique entre la jonction p/n et l'hétérojonction, les performances de chaque diode sont sensiblement identiques.

La zone dopée p+ est dopée par un dopant accepteur qui est avantageusement de l'arsenic.

La semelle est en $Hg_{1-x}Cd_xTe$ avec x ayant une valeur comprise de préférence entre 0,15 et 0,95, par exemple 0,3. Cette valeur de x traduit une valeur de la première concentration en cadmium et permet de la calculer. La valeur de x est sensiblement égale à deux fois la valeur de la première concentration en cadmium.

De même, le caisson est en $Hg_{1-y}Cd_yTe$ avec y ayant une valeur avantageusement comprise entre 0,15 et 0,95, strictement supérieure à la valeur de x. La valeur de y traduit une valeur de la deuxième concentration en cadmium et permet de la calculer. Ces valeurs de x et y assurent que les diodes seront sensibles à des longueurs d'ondes comprises dans un spectre de l'infrarouge. La valeur de y est sensiblement égale à deux fois la valeur de la deuxième concentration.

De préférence les valeurs de x et de y n'ont pas un écart trop important. En particulier cet écart est inférieur à 0,5 ou 0,2. Si l'écart des valeurs entre x et y était trop important, il pourrait se former un saut de gap important entre la semelle et tout contact conducteur. Cet écart de gap important devrait alors être franchi par tout trou issu d'une interaction entre l'onde électromagnétique et la semelle. Cela pourrait induire dans certains cas une baisse de rendement du dispositif de détection ou une augmentation de la puissance consommée.

L'invention concerne aussi un procédé de réalisation d'un dispositif à au moins une diode p/n à hétérostructure selon l'invention. Ce procédé comporte les étapes successives suivantes :

a) implantation ionique d'un dopant accepteur dans un substrat en $Hg_{1-x}Cd_xTe$, comportant des donneurs extrinsèques de type n, ayant une première concentration en cadmium, appelé semelle,
b) diffusion et activation du dopant implanté dans le substrat, délimitant dans le substrat une zone dopée p+ qui a une forme standard de zone de dopage,
c) dépôt d'une couche de passivation dont un des éléments est du cadmium Cd, par-dessus la semelle et la zone dopée p+ de façon à protéger la diode et à limiter une désorption du mercure hors de la diode, précédant ou suivant l'étape b),
d) comblement de lacunes de mercure initialement présentes dans le substrat ou formées lors de l'étape de diffusion et d'activation du dopant. Suite à l'étape d), tout dopage p induit par les lacunes de mercure disparait, la semelle artificiellement dopée p par l'étape de diffusion et d'activation du dopant redevient dopée n et forme une jonction p+/n, dite jonction p/n avec la zone dopée p+.

La semelle est ainsi définie dans l'étape a) comme une partie du substrat dans laquelle il n'y a pas de dopant accepteur.

Le procédé selon l'invention est caractérisé en ce qu'il comporte, préférentiellement avant l'étape d) et préférentiellement après l'étape b) et l'étape c), une étape d'inter-diffusion sélective du cadmium depuis la couche de passivation dans la zone dopée p+. Ainsi, il est formé une première partie en $Hg_{1-x}Cd_xTe$, de première concentration en cadmium, et une deuxième partie en $Hg_{1-y}Cd_yTe$, dite caisson ou partie concentrée, ayant une deuxième concentration en cadmium, sensiblement constante et supérieure à la première concentration en cadmium de la semelle. Le caisson est localisée à l'intérieur de la zone dopée p+. Ainsi, après l'étape d) de comblement des lacunes, le caisson est circonscrit à l'intérieur d'une zone délimitée par la jonction p/n.

L'étape d'inter-diffusion sélective du procédé selon l'invention permet de former, de façon automatique et sans nécessité de contrôle extérieur, une deuxième partie, concentrée en cadmium, localisée de façon optimisée vis-à-vis de la région dopée p+ et autopositionnée. La diffusion étant sélective, elle est contrôlée par des conditions de fonctionnement de l'étape d'inter-diffusion sélective et par la forme de la zone dopée p+ et ainsi, une maîtrise de la forme de la zone dopée p+ induit une maîtrise du caisson. Il n'y a donc pas de risques d'obtenir une hétérostructure placée de façon inappropriée vis-à-vis de la jonction p/n, la jonction p/n étant définie comme étant une limite entre la zone dopée p+ et la semelle dopée n. De plus, le caisson, plus concentré en cadmium, étant obtenu par diffusion de cadmium dans un réseau cristallin initial, a un réseau cristallin identique à un réseau cristallin initial du substrat.

De préférence, l'étape b) de diffusion et d'activation du dopant est effectuée avant l'étape c) de dépôt de la couche de passivation.

Il est possible d'inverser les étapes b) et c).

L'étape d'inter-diffusion sélective du cadmium comprend avantageusement un recuit de diffusion sélective. Celui-ci est, de préférence, effectué à une température supérieure à 100°C et pendant une durée supérieure à une minute dans des conditions de pression et température qui limitent la dégradation du matériau. La diffusion du cadmium dans la zone dopée p+ est ainsi contrôlée par la température et la durée du recuit qui sont deux paramètre influençant les conditions de fonctionnement de l'étape d'inter-diffusion sélective. Ces paramètres sont identiques pour tout le substrat et sont aisément répétables lors d'une fabrication d'autres dispositifs selon l'invention. Ainsi, sur le même substrat, et d'un substrat à l'autre, la diffusion du cadmium est sensiblement identique vis-à-vis de la zone dopée p+ et ce même si d'une diode à l'autre les zones dopées p+ ont des formes sensiblement différentes. Il y a alors une répétabilité et une reproductibilité importante des caractéristiques du dispositif selon l'invention, en particulier la jonction p/n et le caisson sont agencés avec une position relative sensiblement identique pour toute diode d'un même substrat ou de tout substrat ayant subi un recuit de diffusion dans les mêmes conditions de fonctionnement.

Le dopant accepteur est de préférence de l'arsenic.

L'implantation ionique, que le dopant soit de l'arsenic ou non, peut avoir lieu avec une dose comprise typiquement entre $10^{12}$ et $10^{16}$ at/cm$^2$.

Le caisson, créé par le procédé selon l'invention, a des limites qui forment une interface, appelée hétérojonction, avec le reste du substrat ayant la première concentration en cadmium. Le caisson étant compris à l'intérieur de la zone dopée p+, l'hétérojonction est aussi comprise à l'intérieur de la zone dopée p+. Le caisson ayant un fond et le procédé visant à fabriquer simultanément plusieurs diodes p/n, l'hétérojonction, au niveau du fond du caisson, est à une distance relative moyenne de la jonction p/n sensiblement identique pour toutes les diodes fabriquées lors du procédé, à l'intérieur de la zone dopée p+. Ainsi, le procédé selon l'invention est tel qu'il permet, de par la maîtrise de la température et de la durée de l'étape d'inter-diffusion, de positionner précisément, et de façon répétable, l'hétérojonction par rapport à la jonction p/n.

De préférence enfin, précédant l'étape de dépôt de la couche de passivation, le substrat en totalité a une concentration en cadmium qui est la première concentration. Cela signifie qu'il n'y a pas de couche superficielle en HgCdTe de concentration en cadmium différente de celle du substrat comme cela existe dans l'art antérieur. Le procédé selon l'invention permet donc des gains financiers importants car il est possible de fabriquer des diodes à hétérostructure sans avoir besoin d'un substrat comportant une couche épitaxiée, qui nécessite pour sa fabrication un traitement long et coûteux et qui de plus peut induire une création de défauts.

**BRÈVE DESCRIPTION DES DESSINS**

L'invention sera mieux comprise, et d'autres détails, avantages et caractéristiques de celle-ci apparaîtront à la lecture de la description suivante faite à titre d'exemple non limitatif et en référence aux dessins annexés dans lesquels :

la figure 1 illustre une diode p/n à hétérostructure selon l'état de l'art,
les figures 2A à 2G illustrent diverses étapes d'un procédé de fabrication d'une diode p/n à hétérostructure selon les techniques de l'état de l'art,
la figure 3 illustre une diode p/n à hétérostructure selon le dispositif de l'invention,
les figures 4A à 4G illustrent différentes étapes d'un procédé suivant l'invention,
la figure 5 illustre le positionnement de deux points de mesure SIMS sur une diode selon l'invention,
les figures 6A et 6B illustrent les profils de concentration en cadmium d'une part et en cadmium et en arsenic d'autre part obtenus lors de deux mesures sur la diode selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les figures illustratives des différents modes de réalisation du dispositif selon l'invention sont données à titre d'exemple et ne sont pas limitatives.

**EXPOSÉ DÉTAILLÉ DE MODES DE RÉALISATION PARTICULIERS**

L'invention concerne en premier lieu un dispositif comportant au moins une diode p/n à hétérostructure. Un tel dispositif selon l'invention est illustré en figure 3.

La diode à hétérostructure, présente sur un substrat 101, comporte une couche de matériau semi-conducteur, dite semelle 1, dopée n, et ce matériau semi-conducteur est de type $Hg_{1-x}Cd_xTe$. La semelle 1 en $Hg_{1-x}Cd_xTe$ a une première concentration en cadmium, caractérisée par une composition x de la semelle 1 en cadmium. La composition x est de préférence comprise entre 0,15 et 0,95.

La valeur de x est avantageusement comprise entre 0,15 et 0,25, par exemple 0,22, si l'on désire former une diode sensible à des ondes électromagnétiques infrarouge à longueurs d'ondes dites longues, connues en anglais sous le nom de LWIR (« long wavelength infrared ») en particulier comprises entre 9 µm et 30 µm.

La valeur de x est avantageusement comprise entre 0,25 et 0,4, par exemple 0,3, si l'on désire former une diode sensible à des ondes électromagnétiques infrarouge à longueurs d'ondes dites moyennes, connues en anglais sous le nom de MWIR (« Mid-wavelength infra-red ») en particulier comprises entre 3 $\mu$m et 9 $\mu$m.

La valeur de x est avantageusement comprise entre 0,4 et 0,95, par exemple 0,45, si l'on désire former une diode sensible à des ondes électromagnétiques infrarouge à longueurs d'ondes dites courtes, connues en anglais sous le nom de SWIR (« short wavelength infrared ») en particulier comprises entre 0,8 et 3 $\mu$m.

Dans un exemple de l'invention, la valeur de x est sensiblement égale à 0,3.

La semelle 1 peut être présente sur un côté d'un substrat qui n'est pas représenté dans la figure 3. La semelle 1 peut être présente sur tout type de substrat apte à recevoir une couche en $Hg_{1-x}Cd_xTe$. Cependant, si la diode est destinée à être utilisée dans un imageur, le substrat est choisi comme étant transparent à une gamme de longueurs d'ondes donnée pour laquelle on veut que l'imageur soit sensible. En particulier, le substrat est choisi comme étant transparent à une onde électromagnétique ayant une énergie égale au gap de la semelle. Une autre possibilité est de retirer le substrat lors d'étapes suivantes, si ce dernier n'est pas transparent ou si cette étape améliore les performances du composant.

Par-dessus la semelle 1 est présente une couche de passivation 5 en CdTe. Cette couche est en contact avec la semelle 1.

La semelle 1 comprend d'un côté une région de dopage p formant une zone 9 dopée p+ qui n'est pas en contact avec l'éventuel substrat. La zone 9 dopée p+ est dopée au moyen d'un dopant de type accepteur pour le $Hg_{1-x}Cd_xTe$. L'arsenic (As) est un dopant avantageux de ce type. D'autres dopants de type accepteur susceptibles d'être utilisés sont par exemple le phosphore (P), l'antimoine (Sb), le bismuth (Bi)...ou d'autres atomes. Ces dopants, ainsi que l'arsenic, se positionnent en substitution d'un atome de tellure lors d'une étape d'activation des dopants. Le lithium (Li), le cuivre (Cu) ou l'or (Au), se positionnant en substitution d'un atome de cadmium ou de mercure, sont aussi des dopants accepteurs utilisables dans le cadre de l'invention. Dans la suite de la description, nous présenterons le cas de l'arsenic. Il est bien entendu que l'invention concerne aussi les autres dopants de type accepteur précités.

La zone 9 dopée p+ a une forme comparable à celles retrouvées dans l'état de la technique, aussi bien pour des diodes p/n à hétérostructure, que pour des diodes p/n sans hétérostructure. La zone 9 dopée p+ est donc en contact avec la couche de passivation 5. La zone 9 dopée p+ s'étend de plus de façon finie dans la semelle 1, selon un profil classique de diffusion de dopant, par exemple jusqu'à environ 1 $\mu$m de profondeur dans la semelle 1. L'interface entre la zone 9 dopée p+ et la semelle 1 dopée n forme une jonction p+/n appelée jonction p/n 10.

Il y a avantageusement un contact conducteur 6 qui traverse la couche de passivation 5 et pénètre dans la zone 9 dopée p+, de la même façon que dans une diode selon l'état de la technique.

La diode du dispositif selon l'invention se différentie particulièrement de l'état de la technique en ce qu'une partie, dite partie concentrée 11, plus concentré en cadmium que le restant de la semelle 1 est présente dans la majorité de la zone 9 dopée p+. La partie concentrée 11 est composée de $Hg_{1-y}Cd_yTe$ ayant une deuxième concentration en cadmium strictement supérieure à la première concentration en cadmium. Cette deuxième concentration en cadmium est caractérisée par la composition y en cadmium dans la partie concentrée.

La partie concentrée 11 est en forme d'un caisson 12, de concentration sensiblement constante en cadmium, ayant des limites avec le reste du substrat situées au niveau de la jonction p/n 10. Le substrat comporte donc une hétérostructure composée de la semelle 1 dans laquelle est inséré au moins un caisson 12 en $Hg_{1-y}Cd_y$-Te strictement plus concentré en cadmium que la semelle 1.

Les limites du caisson 12, hormis l'interface avec la couche de passivation 5, forment une hétérojonction 3 avec la semelle 1 de composition x en cadmium. L'hétérojonction 3 est sensiblement située au niveau de la jonction p/n, mais est toujours située sensiblement à l'intérieur de la zone 9 dopée p+. En effet, avantageusement, l'hétérojonction 3 n'est pas superposée avec la jonction p/n, mais se trouve entièrement à l'intérieur de la zone 9 dopée p+. Il y a donc une partie de la zone 9 dopée p+ qui n'est pas à la deuxième concentration.

La composition y est comprise entre 0,15 et 0,95, par exemple 0,5. La composition en cadmium de la partie concentrée 11 est avantageusement sensiblement constante.

De préférence, la valeur de y est comprise dans le même intervalle de valeurs précité que x. La valeur de y peut cependant être comprise dans un autre intervalle de valeur que x, parmi ceux précités, si l'écart entre les valeurs de x et y n'est pas trop important. En particulier cet écart est typiquement inférieur à 0,5. On s'arrangera pour que l'écart entre x et y ne soit pas plus important. Sinon, il pourrait être formé un écart de gap important entre la semelle et tout contact conducteur présent dans la diode. Cet écart de gap important aurait alors besoin d'être franchi par tout trou issu d'une interaction entre l'onde électromagnétique et la semelle. Cela pourrait induire une baisse de rendement du dispositif de détection ou une augmentation de la puissance consommée.

Le substrat selon l'invention comprend alors, en première approximation, une première partie 4 de première concentration en cadmium, comportant la semelle 1, dopée n, et une partie de la zone 9 dopée p+ qui n'est pas à la deuxième concentration.

De préférence une zone intermédiaire ayant une concentration en cadmium intermédiaire entre la première concentration, dans la semelle 1, et la deuxième concentration, dans le caisson 12, est située au niveau de la jonction p/n 10, mais hors du caisson 12.

La zone intermédiaire s'étend de préférence au moins sur toute la partie de la zone 9 dopée p+ qui n'est pas à la deuxième concentration. Cette zone intermédiaire présente un gradient de concentration en cadmium compris entre la première concentration et la deuxième concentration en forme de profil de diffusion classique. Ainsi, lorsqu'il est atteint un équilibre thermodynamique, une zone de charge d'espace, non représentée, se forme autour de la jonction p/n 10, la zone de charge d'espace est majoritairement dans un matériau ayant soit la concentration intermédiaire, soit la deuxième concentration, c'est-à-dire qu'elle a majoritairement une concentration en cadmium plus élevée que la première concentration. En conséquence, la zone de charge d'espace est dans un matériau qui a un gap plus grand que le gap du matériau de la semelle 1. Avantageusement, la jonction p/n est telle qu'une première limite de la zone de charge d'espace est dans la semelle 1 ou dans une partie de la zone intermédiaire ayant une concentration en cadmium proche de celle de la semelle 1 et qu'une seconde limite de la zone de charge d'espace est dans le caisson 12 ou dans une partie de la zone intermédiaire ayant une concentration en cadmium proche de celle du caisson 12.

Le caisson 12 ayant un fond, l'hétérojonction 3 formée par les limites du caisson 12 et la jonction p/n 10 formée par les limites de la zone 9 dopée p+ sont distantes en moyenne, au niveau du fond du caisson 12, d'une distance relative moyenne donnée. L'hétérojonction 3 et la jonction p/n 10 ont alors une position relative donnée. S'il y a plusieurs diodes p/n dans le dispositif selon l'invention, les positions relatives des hétérojonctions 3 et des jonctions p/n sont sensiblement identiques pour toutes les diodes fabriquées lors du procédé.

Ainsi, dans une diode p/n telle que présente dans le dispositif selon l'invention, il y a une hétérostructure 3 qui réduit le bruit dans la diode p/n. De plus, l'hétérojonction 3 n'est présente dans le dispositif qu'à proximité de la jonction p/n 10 et l'hétérojonction est fabriquée sans former de défauts d'interface.

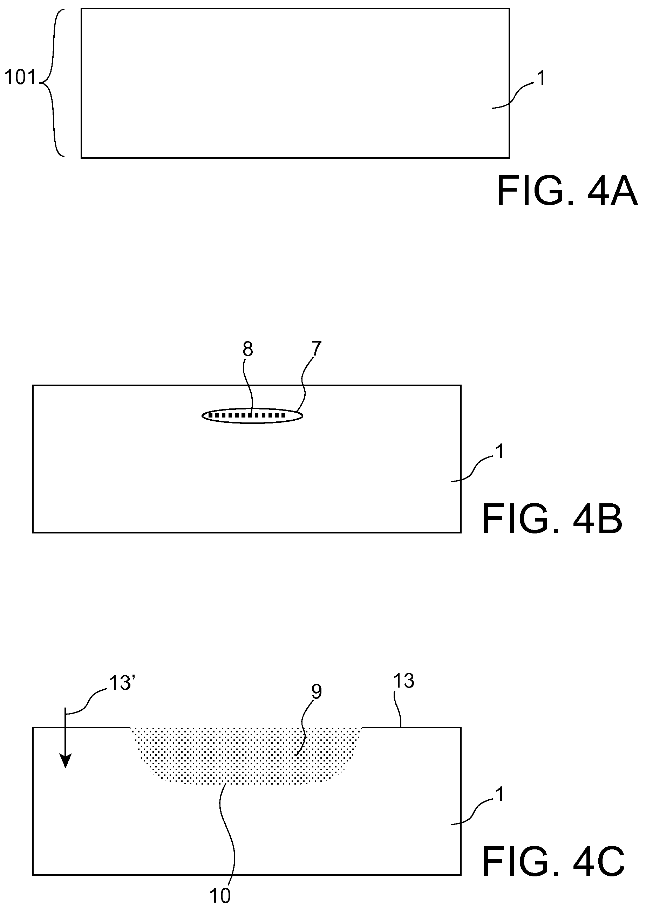

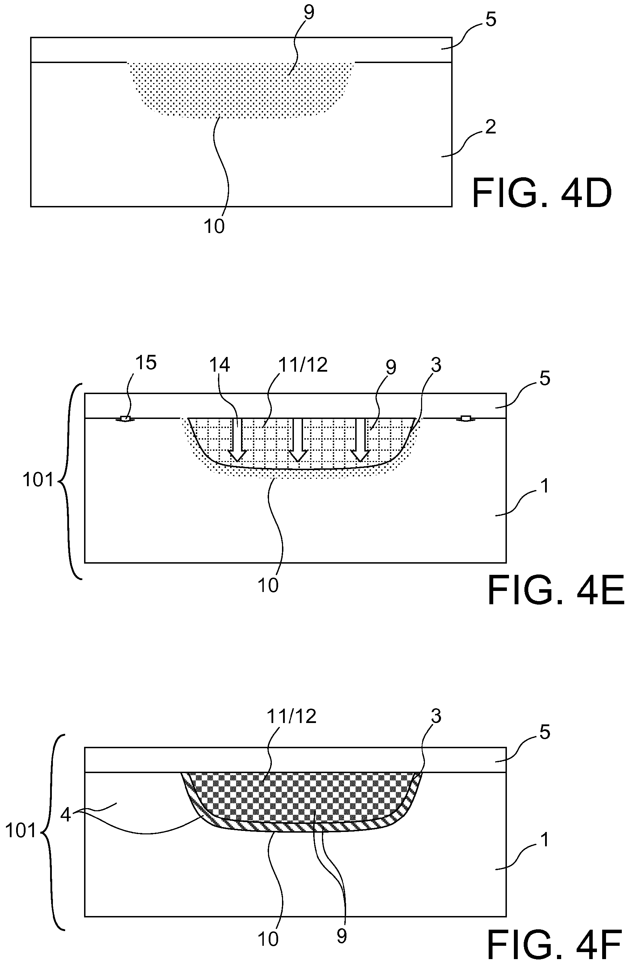

L'invention concerne aussi un procédé pour fabriquer un dispositif selon l'invention. Un tel procédé selon l'invention est décrit ci-dessous en relation avec les figures 4A à 4G.

En premier lieu, on choisit un substrat 101 comportant une couche, dite semelle 1, en un matériau de type $Hg_{1-x}Cd_xTe$ ayant une première concentration en cadmium et de composition telle que définie précédemment (figure 4A). La semelle 1 peut avoir une épaisseur de plusieurs micromètres à quelques dizaines de micromètres, par exemple 10 $\mu$m. Elle peut par exemple avoir été formée par épitaxie par jet moléculaire (EJM) ou par épitaxie en phase liquide (EPL). De préférence, la semelle 1 comporte initialement un dopage n formé par un dopant extrinsèque de type donneur introduit lors de sa formation, par exemple de l'indium. Ce dopant peut avoir une densité faible, connue de l'homme du métier, par exemple typiquement comprise entre $1.E^{14}$ at/cm³ et

$5.E^{16}$ at/cm³. Si le dopant n'est pas introduit lors de la formation de la semelle 1, il est adjoint avant les étapes citées ci-dessous.

Ensuite, comme pour le procédé de l'état de la technique, on procède à une implantation ionique localisée d'un dopant 8 de type accepteur (figure 4B) sous la forme d'atomes de dopant. Le dopant peut être un de ceux cités précédemment dans la description du dispositif, en particulier de l'arsenic. Des conditions d'implantation standard sont par exemple une énergie de 500 KeV et une dose d'implantation de $2.E^{15}$ at/cm². D'autres conditions d'implantation ionique sont utilisables en fonction des performances désirées pour la diode et sont connues de l'homme du métier. L'énergie d'implantation peut varier entre par exemple 10 KeV et 600 KeV et la dose d'implantation peut varier typiquement entre $10^{12}$ et $10^{16}$ at/cm². Du dopant 8 se retrouve implanté dans une zone d'implantation 7, enterrée dans la semelle 1. Il peut y avoir éventuellement une implantation simultanée de plusieurs dopants.

Ensuite une étape de diffusion et d'activation du dopant (figure 4C) est de préférence effectuée. Cette étape est avantageusement accomplie au moyen d'un recuit de diffusion et d'activation du dopant. Les atomes de dopant diffusent alors suivant trois directions : suivant deux directions définissant une surface principale 13 de la semelle 1, et dans une direction 13' perpendiculaire à cette surface principale 13. Durant le recuit, des lacunes de mercure se forment et induisent dans tout le substrat un dopage p, y compris dans la semelle 1 initialement dopée n.

En diffusant, les atomes de dopant sont activés. C'est-à-dire qu'ils se positionnent de façon à donner une polarité p supplémentaire dans le matériau où ils sont. Avec les doses d'implantation généralement utilisées, la polarité supplémentaire induit un dopage p+ dans le matériau où le dopant diffuse. Pour un dopant arsenic, l'activation consiste à positionner les atomes de dopant arsenic en substitution d'atomes de tellure. Le recuit de diffusion et d'activation a généralement lieu sous pression saturante de mercure, à une température préférentiellement comprise entre 300°C et 500°C, pendant une durée comprise préférentiellement entre quelques minutes et quelques heures. Un exemple particulier est une température de 440°C et une durée de 5 heures. Il est bien entendu que l'homme du métier saura adapter le temps et la température du recuit de diffusion et d'activation du dopant en fonction du type de dopant utilisé, des doses d'implantation utilisées et du type d'utilisation prévue pour la diode.

Dans la zone 9 dopée p+, après diffusion et activation, les atomes de dopant accepteur peuvent avoir une densité typiquement comprise entre $10^{15}$ et $10^{20}$ at/cm³. Puis une couche de passivation 5 dont un des éléments est du cadmium Cd est déposée par-dessus la semelle 1. Cette couche peut être obtenue par dépôt physique en phase vapeur (PVD) ou par toute autre technique. Cette couche a une épaisseur typiquement comprise entre 0,5 micromètre et 5 micromètres, par exemple 1 micromètre.

Le recuit de diffusion et d'activation du dopant est ensuite effectué, s'il n'a pas été fait avant le dépôt de la couche de passivation 5.

Puis, les inventeurs proposent une étape d'inter-diffusion sélective du cadmium (figure 4E). Cette étape entraîne une diffusion de cadmium depuis la couche de passivation 5, riche en cadmium, vers la semelle 1 et en particulier de façon sélective vers la zone 9 dopée p+ présente dans la semelle 1, dopée p par les lacunes de mercure.

Pour ce faire, un recuit de diffusion sélective est avantageusement effectué, avec une température supérieure à 100°C. Le recuit peut avoir une durée supérieure à une minute. En particulier, le recuit de diffusion sélective a de préférence une température inférieure à 400°C de façon à limiter toute nouvelle diffusion du dopant.

La diffusion du cadmium est une diffusion ionique. Cela signifie que les atomes de cadmium diffusent sous forme d'ions $Cd^{2+}$ par l'intermédiaire de sites interstitiels. Une longueur D caractéristique de la diffusion peut s'exprimer sous la forme :

$$D = \left(\frac{p}{n_i}\right) D_{Cd^+}$$

avec $D_{Cd+}$ un coefficient de diffusion du cadmium à une température donnée, p une valeur de densité en trous et ni une densité intrinsèque de porteurs dans la semelle 1.

La diffusion de cadmium sera donc facilitée si un ratio [(densité en trous)/$n_i$], dit ratio de diffusion, augmente. Inversement, dans une région de dopage dans laquelle le ratio de diffusion est inférieur à 1, la diffusion du cadmium sera faible.

La diffusion a donc lieu sélectivement dans la zone 9 dopée p+, où la densité de porteurs est de l'ordre de $10^{17}$ à $10^{20}$ at/cm$^3$, par rapport au reste de la semelle 1. En effet, la semelle 1, bien que dopée p, a une trop faible densité en trous par rapport à la densité intrinsèque de porteurs. La diffusion est considérée comme instantanée dans toute la zone 9 dopée p+, tant que la densité en dopant accepteur, ici de l'arsenic, est supérieure à $n_i$.

Le cadmium a donc, dans la zone 9 dopée p+, une longueur de diffusion sélective 14 très supérieure à une longueur de diffusion standard 15 du cadmium, dans la semelle 1 dopée p. La durée et la température du recuit de diffusion sélective sont ajustables afin de maîtriser la longueur de diffusion sélective 14 du cadmium dans la zone 9 dopée p+ ainsi que la quantité de cadmium qui diffuse.

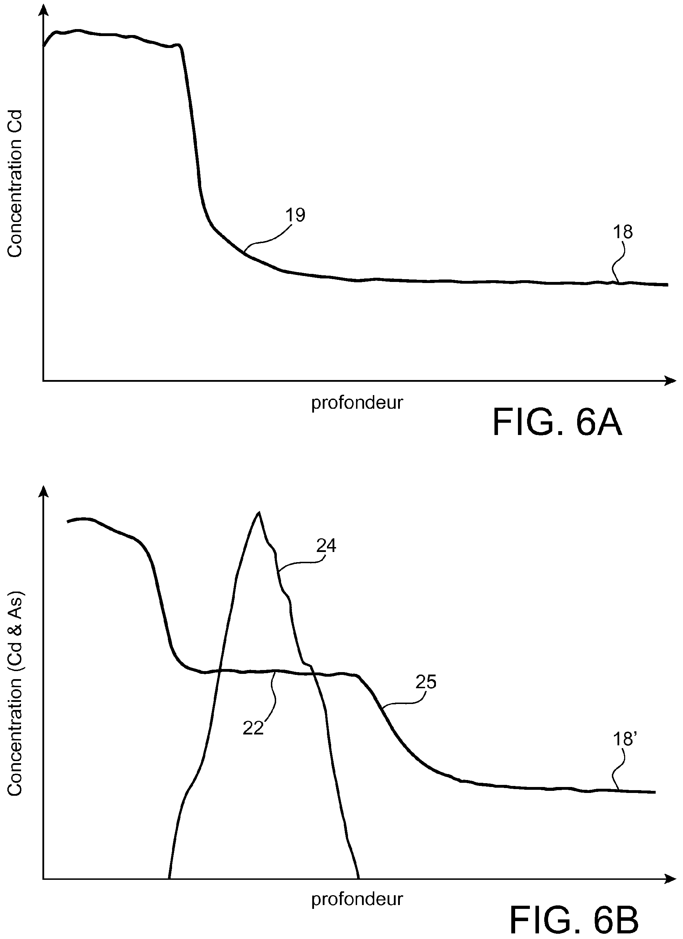

Lors du recuit de diffusion sélective du cadmium, du cadmium diffuse principalement dans la zone dopée p+. Un caisson 12 de $Hg_{1-y}Cd_yTe$ est ainsi formé, ayant une deuxième concentration en cadmium, sensiblement constante, plus riche en cadmium que la semelle 1. L'interface entre le caisson 12 et la semelle 1 est appelée « hétérojonction 3 ». Comme le cadmium diffuse principalement là où l'arsenic est présent en quantité supérieure à la densité intrinsèque de porteurs $n_i$, cela signifie que le caisson 12 est entièrement compris dans la zone 9 dopée p+ et que l'hétérojonction 3 ne dépasse pas de la jonction p/n 10. Entre le caisson 12, de concentration constante, et la semelle 1 se trouve une zone intermédiaire où la concentration en cadmium est intermédiaire entre la première concentration de la semelle 1 et la deuxième concentration du caisson 12. La zone intermédiaire sera décrite plus en détail en liaison avec les figures 6A et 6B. La zone intermédiaire comprend un gradient de diffusion de cadmium dans la semelle, appelé dans l'invention « profil intermédiaire ». La zone intermédiaire et la semelle 1, sont deux portions du substrat qui sont à une concentration différente de la deuxième concentration en cadmium et elles définissent ensemble une première partie 4. Par opposition, s'il y a plusieurs diodes formées, tous les caissons 12 des différentes diodes peuvent être considérés comme appartenant à une deuxième partie, ayant une deuxième concentration en cadmium sensiblement constante en tout point.

La maîtrise de la longueur de diffusion sélective 14 et de la quantité de cadmium qui diffuse assure de contrôler précisément deux paramètres importants : la valeur de la deuxième concentration en cadmium dans le caisson 12, la forme du profil intermédiaire. De plus, s'il est simultanément fabriqué plusieurs diodes sur le substrat 101, comme la diffusion du cadmium est considérée instantanée dans la zone 9 dopée p+, la position relative entre l'hétérojonction 3 et la jonction p/n est aussi fixée de manière sensiblement identique pour toute les diodes comprises sur le substrat 101.

La température et la durée du recuit de diffusion sélective sont des moyens de contrôle pour fixer à la fois la concentration en cadmium dans le caisson 12 et la forme du profil de diffusion de la zone intermédiaire ainsi que sa longueur.

En effet, si la température est basse, le cadmium a un coefficient de diffusion trop faible pour que la diffusion soit significative. Par contre, si la température est trop haute, le coefficient de diffusion est élevé, mais l'arsenic pourrait alors diffuser, ce qui modifierait la forme de la zone 9 dopée p+. Il est possible de trouver une température et un temps de diffusion optimale permettant d'obtenir l'inter-diffusion de cadmium souhaitée sans modifier la zone 9 dopée p+. La température du recuit de diffusion sélective a donc un rôle important et son contrôle permet une maîtrise importante de la diffusion et permet des variations du profil de diffusion et de la quantité de cadmium diffusant. L'ajustement de la durée du recuit autorise des variations plus restreintes mais mieux maîtrisables.

La maîtrise de la longueur de la zone intermédiaire et du profil intermédiaire assure le contrôle de la concentration en cadmium au niveau de la jonction p/n 10 et dans la zone de charge d'espace. On peut ainsi contrôler finement et de façon répétable le gap au niveau de la jonction p/n 10 et les performances de la diode p/n uniquement en faisant varier la température et/ou la durée du recuit et sans nécessiter une maîtrise des dimensions de la zone 9 dopée p+.

Suite à l'étape d'inter-diffusion sélective, le procédé est poursuivi avec des étapes classiques. Une étape de comblement des lacunes de mercure (figure 4F) est réalisée, par laquelle la semelle 1, dopée p, redevient dopée n, les lacunes de mercure, de type accepteur, ayant été comblées. Cette étape peut comporter un recuit à basse température, de température comprise entre 150°C et 350°C, par exemple 250°C durant une période comprise entre quelques minutes et plusieurs jours, par exemple un jour ou deux jours.

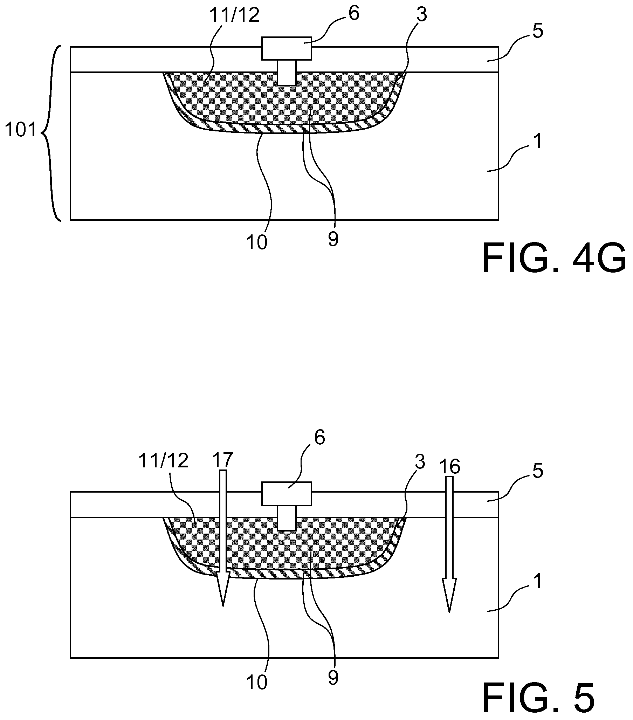

Ensuite, on peut avantageusement former un contact conducteur 6, par exemple métallique, traversant la couche de passivation 5 et pénétrant dans la zone 9 dopée p+ (figure 4G).

Le procédé décrit précédemment permet d'obtenir une diode p/n ayant une hétérostructure telle que l'hétérojonction 3 est localisée dans l'environnement proche de la jonction p/n 10 de la diode, de préférence à l'intérieur d'un volume délimité par la jonction p/n. Cette hétérostructure est auto-positionnée, c'est-à-dire que la réalisation et la position relative de l'hétérostructure par rapport à la jonction p/n 10 sont dues uniquement à des étapes de procédé traitant le substrat 101 de façon globale, sans aucune étape de traitement local tel que gravure, insolation locale... etc. Cela limite les variations locales de paramètres telles que des variations d'une diode p/n à une autre.

Le procédé selon l'invention permet bien d'obtenir le dispositif à au moins une diode p/n selon l'invention. Les inventeurs ont pu montrer que des profils de concentration du cadmium, obtenus par spectrométrie de masse des ions secondaires (SIMS), sont liés à des profils de concentration d'atomes d'arsenic.

La figure 5 illustre un dispositif selon l'invention comportant une zone 9 dopée p+, un caisson 12 plus concentré en cadmium, et une couche de passivation 5 positionnée en contact d'une part avec la zone 9 dopée p+ et d'autre part avec des portions du substrat ayant un dopage n et formant une semelle 1.

Deux mesures de profils de concentration par spectroscopie de masse des ions secondaires (SIMS) ont été effectuées. Des profils de concentration du cadmium et de l'arsenic ont été mesurés. Une première mesure 16 a été effectuée, selon la flèche 16 représentée dans la figure 5, en un endroit où la couche de passivation 5 est en contact avec la semelle 1 de dopage n. Une seconde mesure 17 a été effectuée, selon la flèche 17 représentée dans la figure 5, en un endroit où la couche de passivation 5 est en contact avec la zone 9 dopée p+.

La figure 6A illustre le profil de concentration en cadmium obtenu lors de la première mesure. En ordonnée est présentée la concentration mesurée en unités arbitraires et en abscisse est présentée une mesure de profondeur dans le substrat, en unités arbitraires, telle qu'une surface extérieure de la couche de passivation 5 soit considérée comme origine de l'abscisse. Les références à des éléments structurels de la diode sont à lire en lien avec la figure 5.

Le profil de concentration de cadmium 18 présente un plateau maximum qui semble identifier la couche de passivation 5. Une chute de concentration correspondant au passage dans la semelle 1 en $Hg_{1-x}Cd_xTe$ est ensuite observable. Elle se poursuit rapidement en un plateau final de cadmium correspondant à la concentration en cadmium dans la semelle 1. Dans la semelle 1, proche de la couche de passivation 5, on observe un léger gradient 19 de cadmium supérieur à la quantité de cadmium présente dans le reste de la semelle 1. Ce gradient 19 est le signe d'une diffusion limité de cadmium dans la semelle 1 depuis la couche de passivation 5.

Dans cette mesure, la quantité d'arsenic n'est pas évaluée car non présent.

La figure 6B illustre les profils de concentration obtenus lors de la seconde mesure. En ordonnée est présentée la concentration mesurée en unités arbitraires et en abscisse est présentée une mesure de profondeur dans le substrat, en unités arbitraires, telle qu'une surface extérieure de la couche de passivation 5 soit considérée comme origine de l'abscisse.

En partant de l'abscisse nulle, on observe une zone où le profil de cadmium 18' est maximal. Cette zone correspond à la couche de passivation 5. Il est ensuite observé, dans le sens des abscisses croissantes, une première chute du profil, puis un plateau 22 de cadmium. Suite au plateau 22 de cadmium, une deuxième chute du profil 25 se présente. Le plateau 22 définit une zone correspond au caisson 12 de deuxième concentration en cadmium. La deuxième chute du profil 25 de cadmium correspond à la zone intermédiaire mentionnée plus haut, comportant un gradient de concentration en cadmium de valeurs intermédiaires entre la première concentration et la deuxième concentration.

Le profil de cadmium 18' corrobore la formation d'un caisson en $Hg_{1-y}Cd_yTe$ dans lequel la valeur de la composition y est supérieure à la valeur x traduisant la première concentration en cadmium dans la semelle 1.

Il est ensuite étudié un profil d'arsenic 24 obtenu lors de la deuxième mesure. Un pic du profil d'arsenic 24 faisant toute la longueur du plateau de cadmium 22 est observable de façon superposée au plateau de cadmium 22. Connaissant le procédé, dans lequel la diffusion du cadmium à lieu après toute diffusion de l'arsenic, cette superposition montre que la diffusion du cadmium a bien lieu dans une zone définie par la présence d'arsenic.

Le positionnement de la jonction p/n 10 peut être observé. La jonction p/n, selon une observation des profils de la figure 6B, est située au niveau de la chute de profil 25 du profil de cadmium 18'. Il est ainsi observable que la jonction p/n est située plus profondément que le caisson 12, dans la zone intermédiaire identifiée par le gradient de concentration de la deuxième chute du profil 25 de cadmium. La zone intermédiaire est à cheval entre une région de la semelle 1 dopée n et la zone 9 dopée p+.

L'homme du métier comprendra aisément qu'il est possible de moduler la longueur et la concentration en cadmium dans le gradient de la chute de profil 25 au moyen des conditions de fonctionnement du recuit de diffusion sélective comme mentionné précédemment.

Une telle analyse SIMS montre que le procédé selon l'invention est bien capable de produire des diodes à hétérostructure 3 auto-positionnée dans une semelle 1 en $Hg_{1-x}Cd_xTe$ et de contrôler la concentration en cadmium dans la jonction p/n 10 de la diode et dans la zone de charge d'espace se formant autour de la jonction p/n.

Le procédé et le dispositif selon l'invention permettent d'obtenir des réseaux de diodes ou des diodes seules pour fabriquer en particulier des imageurs infrarouges capables de détecter des ondes électromagnétiques de faible énergie tout en minimisant le bruit et le courant d'obscurité et en ayant une meilleure homogénéité de performances de diodes.

## Revendications

1. Dispositif à au moins une diode p/n à hétérostructure, comportant un substrat à base de HgCdTe, majoritairement dopé n, ledit substrat comportant pour chaque diode :

    - une première partie (4) ayant une première concentration en cadmium,
    - une deuxième partie (11) ayant une deuxième concentration en cadmium, supérieure à la première concentration en cadmium, la deuxième partie, dite partie concentrée (11), formant une hétérostructure (3) avec la première partie (4),
    - une zone (9) dopée p+, dite de dopage p, située dans la partie concentrée (11) et s'étendant jusque dans la première partie (4), et formant une jonction p/n (10) avec une portion dopée n de la première partie (4), appelée semelle (1), de telle sorte qu'une seconde limite (7.2) d'une zone de charge d'espace respective (7.0) de chaque jonction p/n (10) soit située dans un matériau ayant une largeur de bande interdite plus importante que celle de la première partie (4),

    **caractérisé en ce que** :

    - la partie concentrée (11) est localisée uniquement dans la zone (9) dopée p+ et forme un caisson (12) de concentration en cadmium sensiblement constante.

2. Dispositif selon la revendication 1 dans lequel le caisson (12) a un fond situé à une distance relative moyenne (D) sensiblement constante vis-à-vis de la jonction p/n (10).

3. Dispositif selon la revendication 2 dans lequel, lorsqu'il comporte au moins deux diodes p/n à hétérostructure voisines, les caissons (12) des deux diodes voisines sont disjoints et la distance relative moyenne (D) de l'une des deux diodes est sensiblement égale à la distance relative moyenne (D) de l'autre diode.

4. Dispositif selon l'une des revendications 1 à 3 dans lequel, la zone (9) dopée p+ est dopée par un dopant accepteur (8).

5. Dispositif selon la revendication 4, dans lequel le dopant accepteur (8) est de l'arsenic.

6. Dispositif selon l'une des revendications 1 à 5 dans lequel la semelle (1) est en $Hg_{1-x}Cd_xTe$ avec x ayant une valeur comprise entre 0,15 et 0,95 et traduisant la première concentration en cadmium.

7. Dispositif selon la revendication 6 dans lequel le caisson (12) est en $Hg_{1-y}Cd_yTe$ avec y ayant une valeur supérieure à 0,15 et inférieure ou égale à 0,95, strictement supérieure à la valeur de x, et traduisant la deuxième concentration en cadmium.

8. Procédé de réalisation d'un dispositif à au moins une diode p/n à hétérostructure selon la revendication 1, comportant les étapes successives suivantes :

    a) implantation ionique d'un dopant (8) accepteur dans un substrat (101) en $Hg_{1-x}Cd_xTe$, ayant une première concentration en cadmium, comportant des donneurs extrinsèques de type n, appelé semelle (1),
    b) diffusion et activation du dopant (8) dans le substrat, délimitant une zone (9) dopée p+ dans le substrat,
    c) dépôt d'une couche de passivation (5) dont un des éléments est du cadmium Cd par-dessus la semelle (1) et la zone (9) dopée p+, précédant ou suivant l'étape b),
    d) comblement de lacunes de mercure initialement présentes dans le substrat ou formées lors de l'étape de diffusion et d'activation du dopant, la semelle (1) devenant dopée n et formant une jonction p+/n, appelée jonction p/n (10), avec la zone (9) dopée p+,

    **caractérisé en ce qu'**il comporte, avant l'étape d) et après les étapes b) et c), une étape d'inter-diffusion sélective du cadmium depuis la couche de passivation (5) dans la zone (9) dopée p+, formant une première partie (4) en $Hg_{1-x}Cd_xTe$, de première concentration en cadmium, et une deuxième partie (11) en $Hg_{1-y}Cd_yTe$, dite caisson (12) ou partie concentrée, ayant une deuxième concentration en cadmium sensiblement constante et supérieure à la première concentration en cadmium, le caisson (12) étant localisé à l'intérieur de la zone (9) dopée p+.

9. Procédé selon la revendication 8, dans lequel l'étape d'inter-diffusion sélective du cadmium comprend un recuit de diffusion sélective effectué à une température supérieure à 100°C pendant une durée supérieure à une minute.

10. Procédé selon l'une des revendications 8 à 9, dans lequel le dopant accepteur (8) est de l'arsenic.

11. Procédé selon l'une des revendications 8 à 10, dans lequel le caisson (12) a des limites formant une interface appelée hétérojonction (3) localisée au niveau de la jonction p/n (10), le caisson (12) ayant un fond, et le procédé visant à fabriquer simultanément plusieurs diodes p/n, l'hétérojonction (3), au niveau du fond du caisson (12), est à une distance relative moyenne (D) de la jonction p/n (10) sensiblement identique pour toutes les diodes fabriquées lors du procédé, à l'intérieur de la zone (9) dopée p+.

12. Procédé selon l'une des revendications 8 à 11, dans lequel avant l'étape de dépôt de la couche de passivation (5), le substrat (101) en totalité a une concentration en cadmium qui est la première concentration.

**Patentansprüche**

1. Vorrichtung mit wenigstens einer p-n-Diode mit Heterostruktur, umfassend ein Substrat auf der Basis von HgCdTe, mehrheitlich n-dotiert, wobei das genannte Substrat für jede Diode umfasst:

   - einen ersten Teil (4) mit einer ersten Cadmium-Konzentration,
   - einen zweiten Teil (11) mit einer zweiten Cadmium-Konzentration, höher als die erste Cadmium-Konzentration, wobei der zweite Teil, konzentrierter Teil (11) genannt, mit dem ersten Teil (4) eine Heterostruktur (3) bildet,
   - einen p$^+$-dotierten Bereich (9), sogenannten p-Dotierungsbereich (9), der sich in dem konzentrierten Teil (11) befindet und sich bis in den ersten Teil (4) erstreckt und mit einem Sohle (1) genannten n-dotierten Teilstück des ersten Teils (4) einen p-n-Übergang (10) bildet, so dass eine zweite Grenze (7.2) einer jeweiligen Raumladungszone (7.0) von jedem p-n-Übergang (10) in einem Material ist, das eine größere Bandlückenbreite als die des ersten Teils (4) hat,

**dadurch gekennzeichnet, dass** :

   - der konzentrierte Teil (11) nur in dem p$^+$-dotierten Bereich (9) lokalisiert ist und eine Wanne (12) mit im Wesentlichen konstanter Cadmium-Konzentration bildet.

2. Vorrichtung nach Anspruch 1, bei der die Wanne (12) einen Boden hat, der gegenüber dem p-n-Übergang (10) einen im Wesentlichen konstanten mittleren Relativabstand (D) aufweist.

3. Vorrichtung nach Anspruch 2, bei der, wenn sie wenigstens zwei benachbarte p-n-Dioden mit Heterostruktur umfasst, die Wannen (12) der beiden benachbarten Dioden getrennt sind und der mittlere Relativabstand (D) von einer der beiden Dioden im Wesentlichen gleich dem mittleren Relativabstand (D) der anderen Diode ist.

4. Vorrichtung nach einem der Ansprüche 1 bis 3, bei der der p$^+$-dotierte Bereich (9) mit einem Akzeptor-Dotierstoff (8) dotiert ist.

5. Vorrichtung nach Anspruch 4, bei der der Akzeptor-Dotierstoff (8) das Arsen ist.

6. Vorrichtung nach einem der Ansprüche 1 bis 5, bei der die Sohle (1) aus $Hg_{1-x}Cd_xTe$ ist, wobei x einen zwischen 0,15 und 0,95 enthaltenen Wert hat und die zweite Cadmium-Konzentration wiedergibt.

7. Vorrichtung nach Anspruch 6, bei der die Wanne (12) aus $Hg_{1-y}Cd_yTe$ ist, wobei y einen Wert höher als 0,15 und niedriger oder gleich 0,95 aufweist, strikt höher als der Wert von x und die zweite Cadmium-Konzentration wiedergebend.

8. Verfahren zur Herstellung einer Vorrichtung mit wenigstens einer p-n-Diode mit Heterostruktur nach Anspruch 1, die folgenden sukzessiven Schritte umfassend :

   a) Ionenimplantation eines Dotierstoffs (8) in ein Substrat (101) aus $Hg_{1-x}Cd_xTe$ mit einer ersten Cadmium-Konzentration, extrinsische Donatoren des Typs n umfassend, Sohle (1) genannt,
   b) Diffusion und Aktivierung des Dotierstoffs (8) in dem Substrat, einen p$^+$-dotierten Bereich (9) abgrenzend,
   c) Abscheiden einer Passivierungsschicht (5), bei der eines der Elemente Cadmium Cd ist, über der Sohle (1) und dem p$^+$-dotierten Bereich (9), vor oder nach dem Schritt b),
   d) Auffüllen von Quecksilberlücken, die in dem Substrat ursprünglich vorhanden waren oder sich während des Diffusions- und Aktivierungsschritts gebildet haben, wobei die Sohle (1) n-dotiert wird und mit dem $p^+$-dotierten Bereich (9) einen $p^+$-n-Übergang, p-n-Übergang (10) genannt, bildet,

**dadurch gekennzeichnet, dass** es, vor dem Schritt d) und nach den Schritten b) und c), einen selektiven Interdiffusions-schritt des Cadmiums aus der Passivierungsschicht (5) in den $p^+$-dotierten Bereich (9) umfasst, so dass sich ein erster Teil (4) aus $Hg_{1-x}Cd_xTe$ mit einer ersten Cadmium-Konzentration und ein zweiter Teil (11) aus $Hg_{1-y}Cd_yTe$ bildet, Wanne (12) oder konzentrierter Teil genannt, mit einer zweiten Cadmium-Konzentration, die im Wesentlichen konstant und höher als die erste Cadmium-Konzentration ist, wobei die Wanne (12) im Innern des $p^+$-dotierten Bereichs (9) lokalisiert ist.

**9.** Verfahren nach Anspruch 8, bei dem der selektive Cadmium-Interdiffusionsschritt ein selektives Diffusionstempern umfasst, durchgeführt bei einer Temperatur über 100 °C während einer Dauer von mehr als einer Minute.

**10.** Verfahren nach einem der Ansprüche 8 bis 9, bei dem der Akzeptor-Dotierstoff (8) Arsen ist.

**11.** Verfahren nach einem der Ansprüche 8 bis 10, bei dem die Wanne (12) Grenzen hat, die eine in Höhe des p-n-Übergangs (10) lokalisierte und Heteroübergang genannte Schnittstelle (3) bilden, wobei die Wanne (12) einen Boden hat und das Verfahren die simultane Herstellung mehrerer p-n-Dioden vorsieht, und der Heteroübergang (3) in Höhe des Bodens der Wanne (12) einen mittleren Relativabstand (D) von dem p-n-Übergang (10) aufweist, der im Wesentlichen gleich ist für alle während des Verfahrens hergestellten Dioden, innerhalb des $p^+$-dotierten Bereichs (9).

**12.** Verfahren nach einem der Ansprüche 8 bis 11, bei dem das Substrat (101) vor dem Schritt zur Abscheidung der Passivierungsschicht (5) in seiner Gesamtheit eine Cadmium-Konzentration aufweist, die die erste Konzentration ist.

**Claims**

**1.** Device having at least one heterostructure p/n diode, comprising a substrate based on HgCdTe, mostly n-doped, said substrate comprising for each diode:

- a first part (4) having a first cadmium concentration,
- a second part (11) having a second cadmium concentration, greater than the first cadmium concentration, the second part, or concentrated part (11), forming a heterostructure (3) with the first part (4),
- a p+ doped zone (9), or p doping zone, situated in the concentrated part (11) and extending into the first part (4), and forming a p/n junction (10) with an n-doped portion of the first part (4), named base plate (1), such that a second boundary (7.2) of a respective depletion region (7.0) of each p/n junction (10) is located in a material having a larger gap than that of the first part (4),

**characterised in that**:

- the concentrated part (11) is only located in the p+ doped zone (9) and forms a substantially constant cadmium concentration well (12).

**2.** Device according to claim 1 wherein the well (12) has a base situated at a substantially constant mean distance (D) in respect of the p/n junction (10).

**3.** Device according to claim 2 wherein, when it comprises at least two adjacent heterostructure p/n diodes, the wells (12) of the two adjacent diodes are separated and the mean relative distance (D) in one of the two diodes is substantially equal to the mean relative distance (D) in the other diode.

**4.** Device according to any of claims 1 to 3 wherein, the p+ doped zone (9) is doped with an acceptor dopant (8).

**5.** Device according to claim 4, wherein the acceptor dopant (8) is arsenic.

**6.** Device according to any of claims 1 to 5 wherein the base plate (1) is made of $Hg_{1-x}Cd_xTe$ where x has a value between 0.15 and 0.95 and conveys the first cadmium concentration.

**7.** Device according to claim 6 wherein the well (12) is made of $Hg_{1-y}Cd_yTe$ where y has a value greater than 0.15 and less than or equal to 0.95, strictly greater than the value of x, and conveys the second cadmium concentration.

**8.** Method for producing a device having at least one heterostructure p/n diode according to claim 1, comprising the following successive steps:

a) ion implantation of an acceptor dopant (8) in a substrate (101) made of $Hg_{1-x}Cd_xTe$, having a first cadmium concentration, comprising n type extrinsic donors, named a base plate (1),
b) diffusion and activation of the dopant (8) in the substrate, defining a p+ doped zone (9) in the substrate,
c) deposition of a passivation layer (5) wherein one of the elements is cadmium Cd, on top of the base plate (1) and the p+ doped zone (9), prior to or following step b),

d) filling of mercury gaps initially present in the substrate or formed during the step for diffusing and activating the dopant, the base plate (1) becoming n-doped and forming a p+/n junction, named p/n junction (10), with the p+ doped zone (9),

**characterised in that** it comprises, before step d) and after steps b) and c), a step for the selective inter-diffusion of cadmium from the passivation layer (5) into the p+ doped zone (9), forming a first part (4) made of $Hg_{1-x}Cd_xTe$, having a first cadmium concentration, and a second part (11) made of $Hg_{1-y}Cd_yTe$, named well (12) or concentrated part, having a second cadmium concentration , which is substantially constant and greater than the first cadmium concentration, the well (12) being located inside the p+ doped zone (9).

9. Method according to claim 8, wherein the selective cadmium inter-diffusion step comprises selective diffusion annealing performed at a temperature greater than 100°C and for a time greater than one minute.

10. Method according to any of claims 8 to 9, wherein the acceptor dopant (8) is arsenic.

11. Method according to any of claims 8 to 10, wherein the well (12) has boundaries forming an interface, named heterojunction (3), located at the p/n junction (10), the well (12) having a base, and the method being intended to produce a plurality of p/n diodes simultaneously, the heterojunction (3), at the base of the well (12), is at a substantially identical mean relative distance (D) from the p/n junction (10) for all the diodes produced during the method, inside the p+ doped zone (9).

12. Method according to any of claims 8 to 11, wherein prior to the step for depositing the passivation layer (5), the entire substrate (101) has a cadmium concentration which is the first concentration.

FIG. 1

FIG. 2A

FIG. 2B

8.0  7.0  2.0
3.0
1.0

FIG. 2C

9.0  10.0  2.0
3.0
1.0

FIG. 2D

9.0  5.0
2.0
1.0

FIG. 2E

FIG. 2F

FIG. 2G

FIG. 3

FIG. 4A

FIG. 4B

FIG. 4C

FIG. 4D

FIG. 4E

FIG. 4F

FIG. 4G

FIG. 5

FIG. 6A

FIG. 6B

**RÉFÉRENCES CITÉES DANS LA DESCRIPTION**

**Littérature non-brevet citée dans la description**

- **J.M ARIAS et al.** MBE HgCdTe Heterostructure p-on-n Planar Infrared Photodiodes. *Journal of Electronic Materials,* 1993, vol. 22 (8), 1049-1053